# EUROPEAN PATENT SPECIFICATION

(11) **EP 1 530 092 B1**
(45) Date of publication and mention of the grant of the patent: **29.10.2008**
(21) Application number: 04256798.2
(22) Date of filing: 03.11.2004
(51) Int. Cl.: G03F 7/20, G02F 1/21

(54) **Lithographic apparatus and device manufacturing method**
Lithographischer Apparat und Methode zur Herstellung einer Vorrichtung
Appareil lithographique et méthode de fabrication d'un dispositif

(30) Priority: 07.11.2003 EP 03257056
(43) Date of publication of application: 11.05.2005
(73) Proprietor: ASML Netherlands B.V., 5504 DR Veldhoven (NL)
(72) Inventor: Bleeker, Arno Jan, 5563 CE Westerhoven (NL)
(74) Representative: Leeming, John Gerard

(56) References cited:
- US-A- 4 786 128
- US-A- 5 989 752
- US-A- 6 084 656
- US-A1- 2003 036 750
- US-B1- 6 211 993

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs), flat panel displays and other devices involving fine structures. In a conventional lithographic apparatus, a patterning means, which is alternatively referred to as a mask or a reticle, may be used to generate a circuit pattern corresponding to an individual layer of the IC (or other device), and this pattern can be imaged onto a target portion (e.g. comprising part of, one or several dies) on a substrate (e.g. a silicon wafer or glass plate) that has a layer of radiation-sensitive material (resist). Instead of a mask, the patterning means may comprise an array of individually controllable elements which serve to generate the circuit pattern.

In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

Presently used arrays of individually controllable elements include the following:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. It will be appreciated that, as an alternative, the filter may filter out the diffracted light, leaving the undiffracted light to reach the substrate. An array of diffractive optical MEMS devices can also be used in a corresponding manner. Each diffractive optical MEMS device is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the array of individually controllable elements can comprise one or more programmable mirror arrays. More information on mirror arrays as here referred to can be gleaned, for example, from United States Patents US 5,296,891 and US 5,523,193, and PCT patent applications WO 98/38597 and WO 98/33096.
- A programmable LCD array. An example of such a construction is given in United States Patent US 5,229,872.

Conventional devices used as arrays of individually controllable elements, as described above, are difficult to manufacture and, consequently, the yields for their manufacturing processes are low. This results in increased costs. Furthermore, reducing the pixel size on such arrays of individually controllable elements further increases the difficulty in manufacturing the devices and therefore further reduces the manufacturing yields.

US 6,211,993 discloses a solid state device used to modulate the intensity of reflected or transmitted light; the device includes a dielectric stack of alternating layers of different index of refraction materials between conductive layers that are connected to a voltage generator; at least one layer may change its index of refraction when an electric field is applied, changing the reflectivity of the device.

It is an object of the present invention to provide an alternative array of individually controllable elements for use in lithographic projection apparatus.

According to an aspect of the invention, there is provided a lithographic apparatus comprising:
- an illumination system that conditions a projection beam of radiation;
- an array of individually controllable elements serving to impart the projection beam with a pattern in its cross-section;
- a substrate table that supports a substrate; and
- a projection system that projects the patterned beam onto a target portion of the substrate;
wherein each of said individually controllable elements comprises a stack of three dielectric layers, at least the middle one of said layers being formed of a solid state electro-optical material, whereby on application of a control signal said element may be selectively changed between a first state in which there is a relatively greater difference in refractive index for one polarization state between the middle one of said three dielectric layers and both of the other two layers, and a second state in which there is a relatively smaller difference in the refractive index for said one polarization state such that the proportions of the radiation that are transmitted and reflected, respectively, at the boundary of the electro-optical material layer with at least one adjacent layer are different in said two states.

Consequently, each element of the array of individually controllable elements can, by the application of a control signal, change the proportion of the radiation that is reflected and the proportion that is transmitted through the stack. Such an array of individually controllable elements can be used as either a transmissive or reflective array of individually controllable elements. Furthermore, the device is simpler to manufacture than conventional arrays of individually controllable elements because each individually controllable element is formed from several layers of material that can be sequentially deposited on a substrate. Consequently the manufacturing yield of such arrays of individually controllable elements will be better than that of conventional devices, even if the size of each of the individually controllable elements in the array is smaller. In addition, because there are no moving parts, such an array of individually controllable elements will be more durable.

Conveniently, additional layers may be added to the stack. This can be used to improve the reflectivity of each individually controllable element, especially if the thickness of each layer is one-quarter of the wavelength of the radiation used.

Preferably, alternate layers of the stack are formed from the material with a fixed refractive index and the remainder are formed from an electro-optical material. The layers of electro-optical material may be arranged such that their respective extraordinary axes are substantially mutually parallel. Therefore, when these layers are set to have a refractive index that is relatively close to that of the fixed refractive index layers, the individually controllable element is relatively transmissive but, when the refractive index of the electro-optical layers is set to a different level than that of the fixed refractive index layers, the individually controllable element is more reflective than if a stack with a single layer of electro-optical material is used.

Alternatively, the layers of electro-optical material may be arranged such that alternate layers are arranged such that their respective extraordinary axes are mutually perpendicular. This allows the transmissive/reflective characteristic of each individually controllable element to be independently controlled for radiation which is plane polarized in two orthogonal directions. Consequently, it is possible to provide simultaneous patterning of a beam of radiation for dual dipole illumination, for example, effectively separately illuminating orthogonally oriented features of the pattern to be set on the array of individually controllable elements.

Layers of electro-optical material within a stack that have mutually parallel respective extraordinary axes can be set together, as described above, for example for enhanced reflection, or, alternatively, different voltages can be applied to each. This may allow independent control of the reflective/transmissive characteristic of the individually controllable element and the phase shift of the radiation introduced by the array of individually controllable elements. Consequently, adjacent elements on the array of individually controllable elements can be set to, for example, reflect the same intensity of radiation as one another but with a relative phase difference. Thus it is possible to form a phase-shifting array of individually controllable elements. With a sufficient number of controllable electro-optical layers, it is possible to provide an array of individually controllable elements that can control the phase and gray-scale of two patterns for dual dipole illumination.

Each of the layers of the electro-optical material within the stack may have control signals applied to it by individually addressable electrodes. Alternatively, in order to simplify the control of the array of individually controllable elements, a group of layers of electro-optical material may share common electrodes if, for example, the same control signal is always to be applied to these layers.

According to a further aspect of the invention, there is provided a device manufacturing method comprising:
- providing a substrate;
- conditioning a projection beam of radiation using an illumination system;
- using an array of individually controllable elements to impart the projection beam with a pattern in its cross-section; and
- projecting the patterned beam of radiation onto a target portion of the substrate,
wherein each of said individually controllable elements comprises a stack of three dielectric layers, at least the middle one of said layers being formed of a solid state electro-optical material, whereby on application of a control signal said element may be selectively changed between a first state in which there is a relatively greater difference in refractive index for one polarization state between the middle one of said three dielectric layers and both of the other two layers, and a second state in which there is a relatively smaller difference in the refractive index for said one polarization state such that the proportions of the radiation that are transmitted and reflected, respectively, at the boundary of the electro-optical material layer with at least one adjacent layer are different in said two states.

The term "array of individually controllable elements" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) are also used in this context.

It should be appreciated that where pre-biasing of features, optical proximity correction features, phase variation techniques and multiple exposure techniques are used, for example, the pattern "displayed" on the array of individually controllable elements may differ substantially from the pattern eventually transferred to a layer of or on the substrate. Similarly, the pattern eventually generated on the substrate may not correspond to the pattern formed at any one instant on the array of individually controllable elements. This may be the case in an arrangement in which the eventual pattern formed on each part of the substrate is built up over a given period of time or a given number of exposures during which the pattern on the array of individually controllable elements and/or the relative position of the substrate changes.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat panel displays, thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multilayer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 408, 355, 365, 248, 193, 157 or 126 nm) and extreme ultra-violet (EUV) radiation (e.g. having a wavelength in the range of 5-20 nm).

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables. In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the array of individually controllable elements and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 depicts an element that can be used to form a programmable patterning means according to the present invention;
- Figure 3 depicts a variant of the element shown in Figure 2;
- Figure 4 depicts a further variant of the element shown in Figure 2; and
- Figure 5 depicts an arrangement for using a programmable patterning means according to the present invention in a lithographic projection apparatus.

### EMBODIMENTS

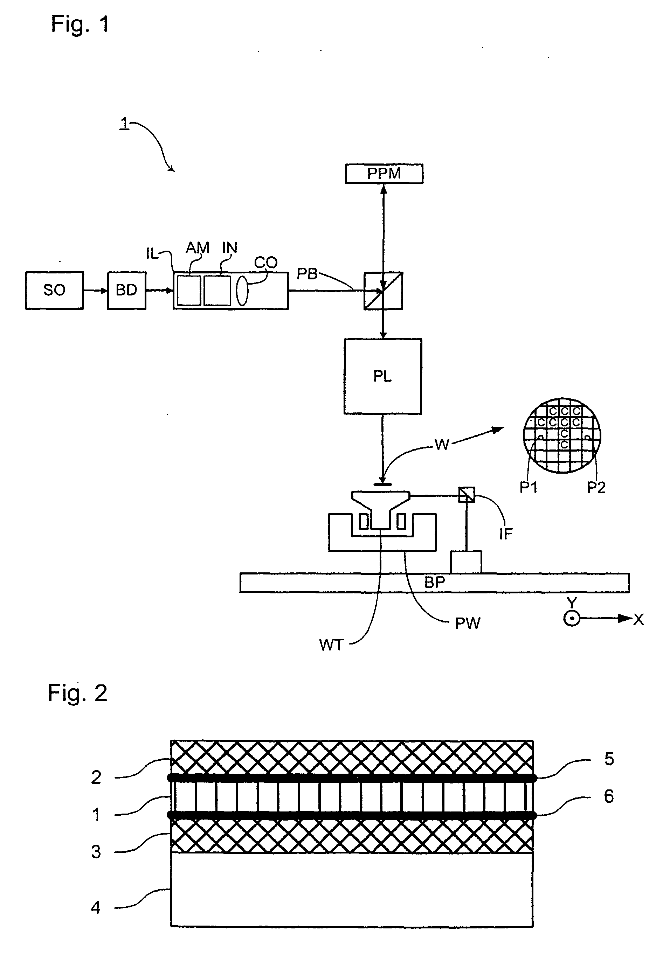

Figure 1 schematically depicts a lithographic projection apparatus according to a particular embodiment of the invention. The apparatus comprises:
- an illumination system (illuminator) IL for providing a projection beam PB of radiation (*e.g.* UV radiation);
- an array of individually controllable elements PPM (e.g. a programmable mirror array) for applying a pattern to the projection beam; in general the position of the array of individually controllable elements will be fixed relative to item PL; however it may instead be connected to a positioning means for accurately positioning it with respect to item PL;
- a substrate table (e.g. a wafer table) WT for supporting a substrate (e.g. a resist-coated wafer) W, and connected to positioning means PW for accurately positioning the substrate with respect to item PL; and
- a projection system ("lens") PL for imaging a pattern imparted to the projection beam PB by the array of individually controllable elements PPM onto a target portion C (e.g. comprising one or more dies) of the substrate W; the projection system may image the array of individually controllable elements onto the substrate; alternatively, the projection system may image secondary sources for which the elements of the array of individually controllable elements act as shutters; the projection system may also comprise an array of focusing elements such as a micro lens array (known as an MLA) or a Fresnel lens array, *e.g.* to form the secondary sources and to image microspots onto the substrate.

As here depicted, the apparatus is of a reflective type (*i. e.* has a reflective array of individually controllable elements). However, in general, it may also be of a transmissive type, for example (*i.e.* with a transmissive array of individually controllable elements).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The beam PB subsequently intercepts the array of individually controllable elements PPM. Having been reflected by the array of individually controllable elements PPM, the beam PB passes through the projection system PL, which focuses the beam PB onto a target portion C of the substrate W. With the aid of the positioning means PW (and interferometric measuring means IF), the substrate table WT can be moved accurately, *e.g.* so as to position different target portions C in the path of the beam PB. Where used, the positioning means for the array of individually controllable elements can be used to accurately correct the position of the array of individually controllable elements PPM with respect to the path of the beam PB, *e.g.* during a scan. In general, movement of the object table WT is realized with the aid of a long-stroke module (course positioning) and a short-stroke module (fine positioning), which are not explicitly depicted in Figure 1. A similar system may also be used to position the array of individually controllable elements. It will be appreciated that the projection beam may alternatively/additionally be moveable while the object table and/or the array of individually controllable elements may have a fixed position to provide the required relative movement. As a further alternative, that may be especially applicable in the manufacture of flat panel displays, the position of the substrate table and the projection system may be fixed and the substrate may be arranged to be moved relative to the substrate table. For example, the substrate table may be provided with a system for scanning the substrate across it at a substantially constant velocity.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the array of individually controllable elements imparts an entire pattern to the projection beam, which is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. Scan mode: the array of individually controllable elements is movable in a given direction (the so-called "scan direction", e.g. the Y direction) with a speed v, so that the projection beam PB is caused to scan over the array of individually controllable elements; concurrently, the substrate table WT is simultaneously moved in the same or opposite direction at a speed V = Mv, in which M is the magnification of the lens PL. In scan mode, the maximum size of the exposure field limits the width (in the non-scanning direction) of the target portion in a single dynamic exposure, whereas the length of the scanning motion determines the height (in the scanning direction) of the target portion.
3. Pulse mode: the array of individually controllable elements is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the array of individually controllable elements is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the array of individually controllable elements is updated as the projection beam scans across the substrate and exposes it.

Combinations and/or variations on the above described modes of use or entirely different modes of use may also be employed.

Each element of the array of individually controllable elements according the present invention, also known as a pixel, is made up of a stack of layers of dielectric material. Figure 2 shows a simple example of such an element. It is comprised of a layer 1 of electro-optical material, sandwiched between two layers 2,3 of dielectric material with a fixed refractive index. The layers 2,3 have the same refractive index. The electro-optical material has the property that its refractive index for radiation which is plane polarized in a given direction can be changed by applying a voltage across the electro-optical material. If the refractive index of the electro-optical material layer 1 is the same as the refractive index of layers 2,3, then the element will be largely transparent. If, however, the refractive index of the electro-optical material 1 is different from that of the layers 2,3 then radiation will be reflected at the boundaries between the layers. By selecting the thickness of the layers to be one-quarter of the wavelength of the radiation that will be incident on the elements of the array of individually controllable elements, the radiation reflected from the boundary between the electro-optical material layer 1 and the first of the fixed refractive index layers 2 will constructively interfere with the radiation reflected from the boundary between the electro-optical material layer 1 and the second layer 3 of fixed refractive index material.

Therefore, by applying a voltage to the electro-optical material layer 1, the element of the array of individually controllable elements can be switched between a state in which all three layers have similar refractive indices and the element is largely transmissive and a state in which the middle layer of the stack, namely the electro-optical material layer 1, has a different refractive index (for radiation which is plane polarized in a given direction) than the adjacent layers and the element is significantly reflective for the radiation which is plane polarized in said direction.

By setting different elements to be reflective or transmissive, a plurality of such elements can be used to pattern a beam of radiation. Clearly, such an array of individually controllable elements can either be used in a reflective mode or a transmissive mode with radiation that is designed to be part of the patterned beam of radiation either being reflected from or transmitted through the elements, respectively.

In practice, the stack will always reflect at least some radiation and always transmit some radiation (even if only radiation which is polarized in the appropriate direction is incident on it). Applying a voltage to the electro-optical material layer 1 simply alters the proportion that is reflected and the proportion that is transmitted, namely the transmission/reflection characteristic. Depending on the composition of the stack, maximum reflection of the element may be obtained by applying no voltage to the stack or by applying a nominal maximum voltage to the stack and, correspondingly, maximum transmission will be obtained by applying the maximum nominal voltage or no voltage, respectively. By applying intermediate voltages, an intermediate level of reflection/transmission of radiation polarized in the given direction will be provided. Therefore the elements of the array of individually controllable elements can be used to provide gray-scales.

For support, the stack of layers of dielectric material may be attached to a substrate 4 (which can be common to all elements in an array of individually controllable elements). If the array of individually controllable elements is to be transmissive then the substrate will need to be selected to be transmissive and it will be necessary to ensure that any reflection of the radiation at the boundary between the stack and the substrate is minimized. If the array of individually controllable elements is to be reflective, then it is essential to ensure that radiation that is transmitted through the stack is not reflected. This may be achieved by selecting a substrate which is transmissive, as before, and directing the radiation transmitted through the substrate out of the system or by selecting a substrate that absorbs the radiation.

The electro-optical material layer 1 may be selected such that when no voltage is applied it has substantially the same refractive index as the fixed refractive index layers 2,3. Alternatively, the electro-optical material layer 1 may be selected to have a different refractive index to the fixed refractive index layers 2,3 when no voltage is applied. Therefore the individually controllable element can be either biased to be transmissive or biased to be reflective, respectively.

As described above, the refractive index of the electro-optical material layer 1 is only voltage-controlled for radiation which is plane polarized in a given direction. Therefore, the electro-optical material layer 1 may be selected such that the refractive index for radiation which is plane polarized in an orthogonal direction is set to filter out the radiation which is plane polarized in that direction. For example, if the individually controllable element is to be used to form a reflective array of individually controllable elements, the refractive index of the electro-optical material layer 1 for radiation which is plane polarized orthogonally to the direction which can be controlled, may be set to be substantially the same as the refractive index of the fixed refractive index layers 2,3 such that this radiation, which can not be controlled by applying a voltage to the electro-optical material layer 1, is transmitted through the individually controllable element and therefore not reflected into the projection system. Consequently, it may not be necessary to illuminate the array of individually controllable elements with radiation which is plane polarized in a given direction. In this case the radiation transmitted through the element (i.e. unpatterned radiation) will need to be prevented from being reflected back into the projection system, namely absorbed or be transmitted through the entire device.

The electro-optical material layer can be formed of, for example, KD*P, KDP, AD*P, ADP, BBO other well-known solid state electro-optical materials. In order to obtain the best response, the electro-optical materials should preferably be operated close to, but above, the Curie temperature of the material used. These are generally lower than ambient temperatures. KDP, for example, has a Curie temperature of 123K and ADP of 148K. Therefore a temperature controlled cooling unit may be provided.

In order to provide the control voltage to the electro-optical material layer 1, transparent electrodes 5, 6 are provided between the electro-optical material layer 1 and the fixed refractive index layers 2,3. Provided these are sufficiently thin, these will not affect the transmission/reflection characteristics of the boundaries between the electro-optical material layer 1 and the fixed refractive index layers 2,3. Alternatively, the electrodes may be applied to the edges of electro-optical material layer, namely faces that are not in contact with the fixed refractive index layers. However, in this case the driving potentials would need to be higher.

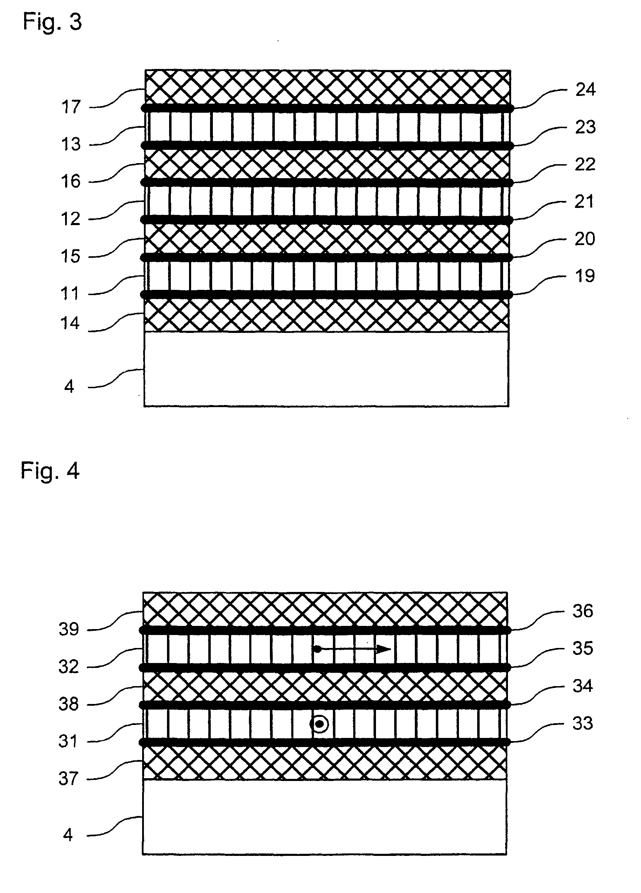

In order to improve the reflectivity of the stack, additional layers may be added as shown in figure 3. As shown, there are three layers 11, 12, 13 of electro-optical material, alternating with layers 14, 15, 16, 17 of material with fixed refractive index. As before, the stack is attached to a substrate 18 for support and electrodes 19 to 24 are provided to apply the control voltages to the electro-optical material layers 11, 12, 13. Although Figure 3 shows the stack with three layers of electro-optical material layer, it will be appreciated that any number of layers may be used in a corresponding fashion.

The electro-optical material layers 11, 12, 13 are oriented such that their respective extraordinary axes are mutually parallel. Consequently, the control voltages applied to them control the transmission/reflection characteristics of their boundaries with the material with fixed refractive index for radiation which is polarized in the same direction.

The control voltage applied to the electro-optical material layer 11 is provided by electrodes 19, 20; the control voltage for electro-optical material layer 12 is provided by electrodes 21, 22; and the control voltage for the electro-optical material layer 13 is provided by electrodes 23, 24. If the individually controllable element is to be used as a simple gray-scale generating element for an array of individually controllable elements, the electrodes for the electro-optical material layers 11, 12, 13 may be connected together such that a common control voltage is applied to each of the electro-optical material layers 11, 12, 13. In other words, electrodes 19, 21, 23 are connected together and electrodes 20, 22, 24 are connected together. Alternatively, the respective pairs of electrodes for each of the electro-optical material layers 11, 12, 13 may be independently addressed with different voltages. This may be used to provide a phase-shifting mask as described below.

Radiation passing through a layer of electro-optical material has its phase shifted. The magnitude of the phase shift is dependant on the voltage that is applied to the electro-optical material layer. Consequently, by providing an individually controllable element with a plurality of electro-optical material layers, it is possible to control not only the total reflection/transmission of the radiation incident on the element (to produce gray-scales) but also to control the total phase shift of the radiation. Therefore it is possible to create a phase difference between radiation propagating from adjacent individually controllable elements, for example, even if the intensity of the radiation is the same. Consequently, these elements can be used to form an array of individually controllable elements that not only generate gray-scales but also is a phase-shifting patterning array.

Each layer of electro-optical material can only control the reflection/transmission characteristic of radiation that is plane polarized in a given direction. Further, by selecting the electro-optical material such that its refractive index, for radiation which is plane polarized in a first direction orthogonal to the direction for which its refractive index is voltage-controllable, is substantially the same as the layers adjacent to it, that portion of the stack will be transmissive to radiation that is plane polarized in the first direction. Figure 4 shows an element for an array of individually controllable elements taking advantage of this feature. It comprises two electro-optical material layers 31, 32, controllable by electrodes 33, 34 and electrodes 35, 36, respectively. The electro-optical material layers 31, 32 are sandwiched between alternating layers 37, 38, 39 of fixed refractive index material and the complete stack is supported on a substrate 4. As shown in Figure 4, the electro-optical material layers 31,32 are arranged such that their respective extraordinary axes are perpendicular to one another. Consequently, applying a voltage to the first electro-optical material layer 31 controls its reflection/transmission characteristic for radiation that is plane polarized in a first direction; and applying a control voltage to the second electro-optical material layer 32 controls its reflection/transmission characteristic for radiation that is plane polarized in a second direction which is perpendicular to the first direction. Consequently, this individually controllable element can be used to independently control radiation that is plane polarized in the first direction and radiation that is plane polarized in the second direction.

In a lithographic projection apparatus, this means that different patterns can be applied to radiation that is plane polarized in two orthogonal directions, allowing simultaneous dual dipole illumination. This is advantageous since imaging a pattern with plane polarized light permits enhanced imaging of features that are elongate in a particular direction. Illumination with polarized radiation has previously been used to illuminate such elongate features but has, for example, required the use of two separate exposures, each with radiation plane polarized in orthogonal directions to separately image the features that are oriented in orthogonal directions. Using elements as shown in Figure 4, it is possible to provide the same effect using a single exposure. For example, the radiation system may have a secondary source plane and be adapted to generate a projection beam with four poles in the secondary source plane. The four poles can be arranged in two pairs such that a line between the centers of the first pair of poles is orthogonal to a line between the centers of the second pair of poles and the lines intersect at the optical axis of the radiation system. Furthermore, the system can be arranged such that the radiation of the first pair of poles is plane polarized in one direction and the radiation of the second pair of poles is plane polarized in a second direction that is orthogonal to the first direction.

As will be apparent, additional electro-optical material layers can be added to the individually controllable element shown in Figure 4. For example, there may be a plurality of electro-optical material layers with extraordinary axes arranged in a first direction and a plurality of electro-optical material layers with their extraordinary axes in a second, perpendicular, direction. With such an arrangement, it is possible to independently control the phase and gray-scale of radiation which is plane polarized in two orthogonal directions.

In an alternative use of the individually controllable element shown in Figure 4 (and corresponding elements with multiple electro-optical material layers arranged perpendicularly to one another), the electrodes may be connected together to provide a common control voltage to the electro-optical material layers that are arranged with the extraordinary axes perpendicular to one another. Consequently, the control of the reflection/transmission characteristic for each will be the same. Therefore the reflection/transmission of radiation which is plane polarized in two orthogonal directions will be the same and therefore arrays of individually controllable elements comprising such elements will not need to be illuminated with plane polarized light. If phase control is required for such an embodiment, then a plurality of pairs of electro-optical material layers can be provided, each pair comprised of electro-optical material layers arranged with their extraordinary axes perpendicular to one another and each pair of layers controlled jointly but independently of the other pairs of electro-optical material layers.

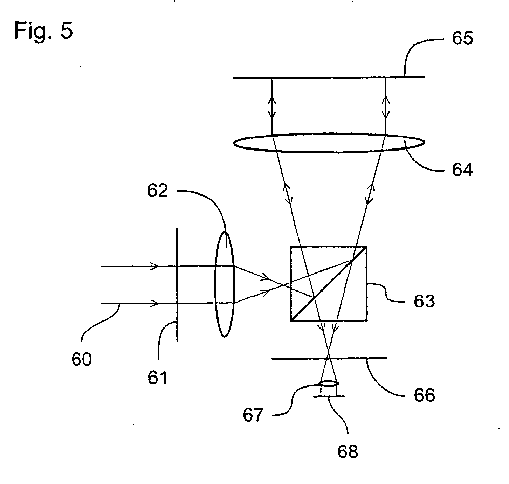

Figure 5 shows an example of the arrangement of components for using an array of individually controllable elements as described above in a lithographic apparatus. Radiation from the illumination system 60 is polarized by a polarizor 61 (so that it is plane polarized in a given direction) and projected onto a beam splitter 63 by way of control optics 62. The beam is reflected by the beam splitter 63 and projected onto the array of individually controllable elements 65 by way of further control optics 64. The beam of radiation is patterned and reflected by the array of individually controllable elements 65 whereupon it is projected through the control optics 64 and transmitted through the beam splitter 63. The patterned beam subsequently passes through a rotational polarizor 66 such as a 1/4 lambda plate before being projected onto the substrate 68 by projection system 67. The 1/4 lambda may be omitted and, in particular, it should be omitted if dual dipole illumination is being used. Furthermore, the polarizor 61 can be omitted by using a polarizing beam splitter instead of standard beam splitter 63. If the elements of the array of individually controllable elements include electro-optical material layers that are arranged to have mutually perpendicular extraordinary axes and that are controlled to operate together then the polarizor 61 can be omitted and the standard beam splitter 63 retained since, as described above, the array of individually controllable elements need not to be illuminated with polarized light. Similarly, where dual dipole illumination is being used the standard (i.e. non-polarizing) beam splitter 63 can be retained but the polarizer 61 must be split up to provide radiation for each dipole direction with its own polarization direction.

While specific embodiments of the invention have been described above, it will be appreciated that the invention may be practiced otherwise than as described. The description is not intended to limit the invention.

## Claims

1. A lithographic apparatus comprising:
- an illumination system (IL) that conditions a projection beam (PB) of radiation;
- an array of individually controllable elements (PPM) serving to impart the projection beam with a pattern in its cross-section;
- a substrate table (WT) that supports a substrate (W); and
- a projection system (PL) that projects the patterned beam onto a target portion (C) of the substrate (W);
wherein each of said individually controllable elements comprises a stack of three dielectric layers (1,2,3), at least the middle one of said layers (1) being formed of an electro-optical material, whereby on application of a control signal said element may be selectively changed between a first state in which there is a relatively greater difference in refractive index for one polarization state between the middle one of said three dielectric layers (1) and both of the other two layers (2,3), and a second state in which there is a relatively smaller difference in the refractive index for said one polarization state **characterized in that** the electro-optical material is a solid state electro-optical material and that the proportions of the radiation that are transmitted and reflected respectively, at the boundary of the electro-optical material layer (1) with at least one adjacent layer are different in said two states.

2. A lithographic projection apparatus according to claim 1, wherein said stack comprises a plurality of additional layers of dielectric material, and at least one of said additional layers is formed from electro-optical material whereby its refractive index, for one polarization state, can be changed by applying a control signal to said second layer of electro-optical material.

3. A lithographic projection apparatus according to claim 1 or 2, wherein alternate layers of said stack are formed from material with a fixed refractive index, the remainder being formed from electro-optical material whereby the refractive index of each layer of electro-optical material, for a given respective polarization state, can be changed by applying respective control signals to said layers.

4. A lithographic projection apparatus according to claim 2 or 3, wherein said layers of electro-optical material are arranged such that their respective extraordinary axes are substantially mutually parallel.

5. A lithographic projection apparatus according to claim 2 or 3, wherein at least two layers of electro-optical material are arranged such that their extraordinary axes are substantially mutually perpendicular.

6. A lithographic projection apparatus according to any one of claims 2 to 5, further comprising electrodes that are configured to apply an independently controllable control voltage to each layer of electro-optical material within the stack.

7. A lithographic projection apparatus according to any one of claims 2 to 5, further comprising electrodes that are configured to apply a common control voltage to two or more layers of electro-optical material within the stack.

8. A lithographic projection apparatus according to claim 3, 4 or 5, further comprising electrodes that are configured to apply a common control voltage to layers of electro-optical material that have substantially mutually parallel extraordinary axes.

9. A lithographic projection apparatus according to any one of the preceding claims,
wherein each element is configured to control the propagation of radiation that is plane polarized in a first direction and, independently, the propagation of radiation that is plane polarized in a second direction that is substantially orthogonal to the first direction.

10. A lithographic projection apparatus according to claim 9, wherein said illumination system has a secondary source plane and is adapted to generate a projection beam having four poles in said secondary source plane.

11. A lithographic projection apparatus according to claim 10, wherein said four poles are arranged in pairs; a line joining the centers of the first pair of poles is orthogonal to a line joining the centers of the second pair of poles; and said lines intersect substantially at the optical axis of the illumination system.

12. A lithographic projection apparatus according to claim 11, wherein the radiation of said first pair of poles is plane polarized in said first direction and said radiation of said second pair of poles is plane polarized in said second direction.

13. A device manufacturing method comprising:
- providing a substrate (W);
- conditioning a projection beam of radiation (PB) using an illumination system (IL);
- using an array of individually controllable elements (PPM) to impart the projection beam with a pattern in its cross-section; and
- projecting the patterned beam of radiation onto a target portion (C) of the substrate (W),
wherein each of said individually controllable elements comprises a stack of three dielectric layers (1,2,3), at least the middle one of said layers (1) being formed of an electro-optical material, whereby on application of a control signal said element may be selectively changed between a first state in which there is a relatively greater difference in refractive index for one polarization state between the middle one of said three dielectric layers (1) and both of the other two layers (2,3), and a second state in which there is a relatively smaller difference in the refractive index for said one polarization state **characterized in that** the electro-optical material is a solid state electro-optical material and that the proportions of the radiation that are transmitted and reflected, respectively, at the boundary of the electro-optical material layer with at least one adjacent layer are different in said two states.

## Patentansprüche

1. Lithographische Vorrichtung, mit:
• einem Beleuchtungssystem (IL), das einen Projektionsstrahl (PB) aus Strahlung konditioniert;
• einer Gruppe einzeln steuerbarer Elemente (PPM), die dazu dienen, dem Projektionsstrahl in seinem Querschnitt ein Muster aufzuprägen;
• einem Substrattisch (WT), der ein Substrat (W) hält; und mit
• einem Projektionssystem (PL), das den gemusterten Strahl auf einen Zielbereich (C) des Substrats (W) projiziert;
wobei jedes der einzeln steuerbaren Elemente einen Stapel aus drei dielektrischen Schichten (1,2,3) umfasst, wobei wenigstens die mittlere dieser Schichten (1) aus einem elektrooptischen Material gebildet ist, wodurch bei Anlegen eines Steuersignals dieses Element zwischen einem ersten Zustand, in dem eine relativ größere Differenz im Brechungsindex für einen Polarisationszustand zwischen der mittleren dieser drei dielektrischen Schichten (1) und den beiden anderen Schichten (2,3) besteht, und einem zweiten Zustand, in dem eine relativ kleinere Differenz im Brechungsindex für diesen einen Polarisationszustand besteht, selektiv gewechselt werden kann,
**dadurch gekennzeichnet, dass** das elektrooptische Material ein elektrooptisches Festkörpermaterial ist und dass die Anteile der Strahlung, die jeweils übertragen und reflektiert werden, an der Grenze der Schicht (1) aus elektrooptischem Material zu wenigstens einer benachbarten Schicht in diesen beiden Zuständen unterschiedlich sind.

2. Lithographische Projektionsvorrichtung nach Anspruch 1, wobei der Stapel eine Vielzahl von zusätzlichen Schichten aus dielektrischem Material umfasst und wenigstens eine dieser zusätzlichen Schichten aus elektrooptischem Material gebildet ist, wodurch ihr Brechungsindex für einen Polarisierungszustand geändert werden kann, indem ein Steuersignal an diese zweite Schicht aus elektrooptischem Material angelegt wird.

3. Lithographische Projektionsvorrichtung nach Anspruch 1 oder 2, wobei alternierende Schichten des Stapels aus Material mit einem fixen Brechungsindex gebildet sind, wobei der Rest aus elektrooptischem Material geformt ist, wodurch der Brechungsindex jeder Schicht aus elektrooptischem Material für einen vorbestimmten jeweiligen Polarisationszustand geändert werden kann, indem jeweilige Steuersignale an diese Schichten angelegt werden.

4. Lithographische Projektionsvorrichtung nach Anspruch 2 oder 3, wobei die Schichten aus elektrooptischem Material so angeordnet sind, dass ihre jeweiligen außerordentlichen Achsen im Wesentlichen parallel zueinander verlaufen.

5. Lithographische Projektionsvorrichtung nach Anspruch 2 oder 3, wobei wenigstens zwei Schichten aus elektrooptischem Material so angeordnet sind, dass ihre außerordentlichen Achsen im Wesentlichen senkrecht zueinander verlaufen.

6. Lithographische Projektionsvorrichtung nach einem der Ansprüche 2 bis 5, ferner mit Elektroden, die so konfiguriert sind, dass sie eine unabhängig steuerbare Steuerspannung an jede Schicht aus elektrooptischem Material innerhalb des Stapels anlegen.

7. Lithographische Projektionsvorrichtung nach einem der Ansprüche 2 bis 5, ferner mit Elektroden, die so konfiguriert sind, dass sie eine gemeinsame Steuerspannung an zwei oder mehr Schichten aus elektrooptischem Material innerhalb des Stapels anlegen.

8. Lithographische Projektionsvorrichtung nach Anspruch 3, 4 oder 5, ferner mit Elektroden, die so konfiguriert sind, dass sie eine gemeinsame Steuerspannung an Schichten aus elektrooptischem Material anlegen, die im Wesentlichen parallel zueinander verlaufende außerordentliche Achsen aufweisen.

9. Lithographische Projektionsvorrichtung nach einem der vorhergehenden Ansprüche, wobei jedes Element so konfiguriert ist, dass es die Verbreitung von Strahlung steuert, die in einer ersten Richtung planpolarisiert ist und, unabhängig, die Verbreitung von Strahlung, die in einer zweiten Richtung planpolarisiert ist, die im Wesentlichen orthogonal zu der ersten Richtung verläuft.

10. Lithographische Projektionsvorrichtung nach Anspruch 9, wobei das Beleuchtungssystem eine sekundäre Quellenebene aufweist und so angepasst ist, dass es einen Projektionsstrahl mit vier Polen in der sekundären Quellenebene erzeugt.

11. Lithographische Projektionsvorrichtung nach Anspruch 10, wobei die vier Pole in Paaren angeordnet sind; wobei eine die Mittelpunkte des ersten Polpaares verbindende Linie orthogonal zu einer Linie ist, die die Mittelpunkte des zweiten Polpaares verbindet; und wobei die Linien im Wesentlichen bei der optischen Achse des Beleuchtungssystems schneiden.

12. Lithographische Projektionsvorrichtung nach Anspruch 11, wobei die Strahlung des ersten Polpaares in der ersten Richtung planpolarisiert ist und die Strahlung des zweiten Polpaares in der zweiten Richtung planpolarisiert ist.

13. Verfahren zur Herstellung eines Bauteils, umfassend:
• Bereitstellen eines Substrats (W);
• Konditionieren eines Projektionsstrahls aus Strahlung (PB) unter Verwendung eines Beleuchtungssystems (IL);
• Verwenden einer Gruppe einzeln steuerbarer Elemente (PPM), um dem Projektionsstrahl in seinem Querschnitt ein Muster aufzuprägen; und
• Projizieren des gemusterten Strahls aus Strahlung auf einen Zielbereich (C) des Substrats (W),
wobei jedes der einzeln steuerbaren Elemente einen Stapel aus drei dielektrischen Schichten (1,2,3) umfasst, wobei wenigstens die mittlere dieser Schichten (1) aus einem elektrooptischen Material gebildet ist, wodurch bei Anlegen eines Steuersignals dieses Element zwischen einem ersten Zustand, in dem eine relativ größere Differenz im Brechungsindex für einen Polarisationszustand zwischen der mittleren dieser drei dielektrischen Schichten (1) und den beiden anderen Schichten (2,3) besteht, und einem zweiten Zustand, in dem eine relativ kleinere Differenz im Brechungsindex für diesen einen Polarisationszustand besteht, selektiv gewechselt werden kann,
**dadurch gekennzeichnet, dass** das elektrooptische Material ein elektrooptisches Festkörpermaterial ist und dass die Anteile der Strahlung, die jeweils übertragen und reflektiert werden, an der Grenze der Schicht (1) aus elektrooptischem Material zu wenigstens einer benachbarten Schicht in diesen beiden Zuständen unterschiedlich sind.

## Revendications

1. Appareil lithographique comprenant :
- un système d'éclairage (IL) qui conditionne un faisceau de projection (PB) de rayonnement ;
- un réseau d'éléments pouvant être individuellement commandés (PPM) servant à doter le faisceau de projection d'un motif dans sa section transversale ;
- une table substrat (WT) qui supporte un substrat (W) ; et
- un système de projection (PL) qui projette le faisceau mis en forme sur une partie cible (C) du substrat (W) ;
dans lequel chacun desdits éléments pouvant être individuellement commandés comprend une pile de trois couches diélectriques (1, 2, 3), au moins la couche centrale desdites couches (1) étant formée d'un matériau électro-optique, de sorte que lors de l'application d'un signal de commande, ledit élément peut être changé de manière sélective entre un premier état dans lequel il y a une différence d'indice de réfraction relativement plus grande pour un état de polarisation entre la couche centrale desdites trois couches diélectriques (1) et les deux autres couches (2, 3), et un second état dans lequel il y a une différence d'indice de réfraction relativement plus petite pour ledit un état de polarisation, **caractérisé en ce que** le matériau électro-optique est un matériau électro-optique semi-conducteur et **en ce que** les proportions du rayonnement qui sont transmises et réfléchies, respectivement, à la frontière de la couche de matériau électro-optique (1) avec au moins une couche adjacente sont différentes dans lesdits deux états.

2. Appareil de projection lithographique selon la revendication 1, dans lequel ladite pile comprend une pluralité de couches supplémentaires de matériau diélectrique, et au moins une desdites couches supplémentaires est formée à partir d'un matériau électro-optique de sorte que son indice de réfraction, pour un état de polarisation, peut être changé en appliquant un signal de commande à ladite deuxième couche de matériau électro-optique.

3. Appareil de projection lithographique selon la revendication 1 ou 2, dans lequel des couches alternées de ladite pile sont formées à partir d'un matériau ayant un indice de réfraction fixe, le reste étant formé à partir d'un matériau électro-optique de sorte que l'indice de réfraction de chaque couche de matériau électro-optique, pour un état de polarisation respectif donné, peut être changé en appliquant des signaux de commande respectifs auxdites couches.

4. Appareil de projection lithographique selon la revendication 2 ou 3, dans lequel lesdites couches de matériau électro-optique sont agencées de telle sorte que leurs axes extraordinaires respectifs sont sensiblement mutuellement parallèles.

5. Appareil de projection lithographique selon la revendication 2 ou 3, dans lequel au moins deux couches de matériau électro-optique sont agencées de telle sorte que leurs axes extraordinaires sont sensiblement mutuellement perpendiculaires.

6. Appareil de projection lithographique selon l'une quelconque des revendications 2 à 5, comprenant en outre des électrodes qui sont configurées pour appliquer une tension de commande pouvant être individuellement commandée à chaque couche de matériau électro-optique dans la pile.

7. Appareil de projection lithographique selon l'une quelconque des revendications 2 à 5, comprenant également des électrodes qui sont configurées pour appliquer une tension de commande commune à deux couches de matériau électro-optique, ou plus, dans la pile.

8. Appareil de projection lithographique selon la revendication 3, 4 ou 5, comprenant de plus des électrodes qui sont configurées pour appliquer une tension de commande commune à des couches de matériau électro-optique qui ont des axes extraordinaires sensiblement mutuellement parallèles.

9. Appareil de projection lithographique selon l'une quelconque des revendications précédentes, dans lequel chaque élément est configuré pour commander la propagation d'un rayonnement qui est polarisé linéairement dans une première direction et, indépendamment, la propagation d'un rayonnement qui est polarisé linéairement dans une seconde direction qui est sensiblement orthogonale à la première direction.

10. Appareil de projection lithographique selon la revendication 9, dans lequel ledit système d'éclairage a un plan de source secondaire et est adapté pour générer un faisceau de projection ayant quatre pôles dans ledit plan de source secondaire.

11. Appareil de projection lithographique selon la revendication 10, dans lequel lesdits quatre pôles sont agencés par paires ; une ligne reliant les centres de la première paire de pôles est orthogonale à une ligne reliant les centres de la seconde paire de pôles ; et lesdites lignes se coupent sensiblement sur l'axe optique du système d'éclairage.

12. Appareil de projection lithographique selon la revendication 11, dans lequel le rayonnement de ladite première paire de pôles est polarisé linéairement dans ladite première direction et ledit rayonnement de ladite seconde paire de pôles est polarisé linéairement dans ladite seconde direction.

13. Procédé de fabrication d'un dispositif comprenant les étapes de :
- fournir un substrat (W) ;
- conditionner un faisceau de projection de rayonnement (PB) en utilisant un système d'éclairage (IL) ;
- utiliser un réseau d'éléments pouvant être individuellement commandés (PPM) pour doter le faisceau de projection d'un motif dans sa section transversale ; et
- projeter le faisceau de rayonnement mis en forme sur une partie cible (C) du substrat (W) ;
dans lequel chacun desdits éléments pouvant être individuellement commandés comprend une pile de trois couches diélectriques (1, 2, 3), au moins la couche centrale desdites couches (1) étant formée d'un matériau électro-optique, de sorte que lors de l'application d'un signal de commande, ledit élément peut être changé de manière sélective entre un premier état dans lequel il y a une différence d'indice de réfraction relativement plus grande pour un état de polarisation entre la couche centrale desdites trois couches diélectriques (1) et les deux autres couches (2, 3), et un second état dans lequel il y a une différence d'indice de réfraction relativement plus petite pour ledit un état de polarisation, **caractérisé en ce que** le matériau électro-optique est un matériau électro-optique semi-conducteur et **en ce que** les proportions du rayonnement qui sont transmises et réfléchies, respectivement, à la frontière de la couche de matériau électro-optique avec au moins une couche adjacente sont différentes dans lesdits deux états.
